Europäisches Patentamt

(19) European Patent Office

Office européen des brevets

(11) Numéro de publication : **0 172 373**
**B1**

(12) **FASCICULE DE BREVET EUROPÉEN**

(45) Date de publication du fascicule du brevet :
02.11.89

(21) Numéro de dépôt : 85108262.8

(22) Date de dépôt : 04.07.85

(51) Int. Cl.⁴ : **H 01 R 13/629**

(54) **Dispositif de visualisation de l'enfichage de connecteurs électriques sur un plateau d'aéronef.**

(30) Priorité : 09.07.84 FR 8410860

(43) Date de publication de la demande :
26.02.86 Bulletin 86/09

(45) Mention de la délivrance du brevet :
02.11.89 Bulletin 89/44

(84) Etats contractants désignés :
DE FR GB IT NL SE

(56) Documents cités :
EP--A-- 0 090 693
DE--B-- 3 005 652
FR--A-- 2 229 611
FR--A-- 2 546 676
US--A-- 3 649 839

(73) Titulaire : **VIBRACHOC, Société Anonyme dite:**
**Parc d'Activités de l'Eglantier C.E. 2804 Lisses**
**F-91028 Evry Cedex (FR)**

(72) Inventeur : **Van-Hecke, Christian**
**52 rue des Crouettes Marchais**
**F-91820 Boutigny Sur Essonne (FR)**
Inventeur : **Pavie, Denis**
**10 rue St-Exupéry**
**F-91610 Ballancourt Sur Essonne (FR)**

(74) Mandataire : **Weinmiller, Jürgen et al**
**Lennéstrasse 9 Postfach 24**
**D-8133 Feldafing (DE)**

Jouve, 18, rue St-Denis, 75001 Paris, France

## Description

La présente invention concerne un plateau d'aéronef recevant un boîtier d'équipements électroniques portant à sa face postérieure des connecteurs électriques, lequel plateau comporte un fond, une paroi postérieure portant des connecteurs électriques, et des bords latéraux de guidage.

Un tel plateau est décrit dans le document FR 2 229 611.

Dans les avions, une pluralité de plateaux d'aéronef sont disposés les uns à côté des autres, en général sur un rack, à un très faible écartement. L'opérateur ne peut donc voir que la face antérieure du boîtier d'équipements électroniques et il ne peut donc jamais être certain que celui-ci se trouve dans sa position la plus reculée correspondant à un parfait enfichage des connecteurs.

La présente invention se propose de remédier à cet inconvénient en permettant à l'opérateur de visualiser le bon état de l'enfichage sans mettre le dispositif sous tension.

Le plateau d'aéronef selon l'invention est caractérisé en ce qu'il comporte un dispositif de contrôle du bon enfichage des connecteurs entre eux, ce dispositif de contrôle étant constitué de moyens optiques disposés vers le bord antérieur du plateau d'aéronef, de moyens de visualisation, disposés également vers le bord antérieur du plateau d'aéronef, de fibres optiques entre les moyens optiques et les moyens de visualisation et un interrupteur optique présentant un poussoir pouvant être repoussé, à l'encontre des moyens élastiques, par la face postérieure du boîtier, lorsque celui-ci parvient à sa position reculée correspondant à la position arrière du boîtier pour laquelle l'enfichage est parfaitement réalisé, ledit interrupteur interrompant le passage d'un signal entre les moyens optiques et les moyens de visualisation quand le poussoir n'est pas sollicité, et autorisant au contraire le passage du signal quand le poussoir est sollicité lorsque la face postérieure du boîtier parvient dans sa position reculée.

De préférence, les moyens optiques et les moyens de visualisation sont disposés sous le plateau, au bord antérieur de celui-ci, et ils sont écartés l'un de l'autre pour qu'un utilisateur, muni d'une source lumineuse telle que par exemple une lampe de poche, puisse illuminer les moyens optiques sans illuminer simultanément les moyens de visualisation, ces différents moyens étant de préférence disposés aux deux extrémités du bord antérieur du plateau d'aéronef pour laisser libre un espace central susceptible de recevoir des moyens de verrouillage.

On peut utiliser plusieurs micro-interrupteurs à la place d'un seul, ces micro-interrupteurs pouvant être reliés soit en parallèle pour assurer un fonctionnement des moyens de visualisation même si l'un des micro-interrupteurs est détérioré, soit en série pour éviter qu'un micro-interrupteur défectueux, constamment bloqué en position de contact, ne donne une fausse indication positive d'enfichage.

D'autres avantages et caractéristiques de l'invention apparaîtront à la lecture de la description suivante, faite à titre d'exemple non limitatif et se référant aux dessins annexés dans lesquels :

La figure 1 représente une vue schématique de côté du plateau d'aéronef.

La figure 2 représente une vue en perspective de l'extrémité antérieure du plateau.

La figure 3 représente une vue schématique de l'interrupteur optique.

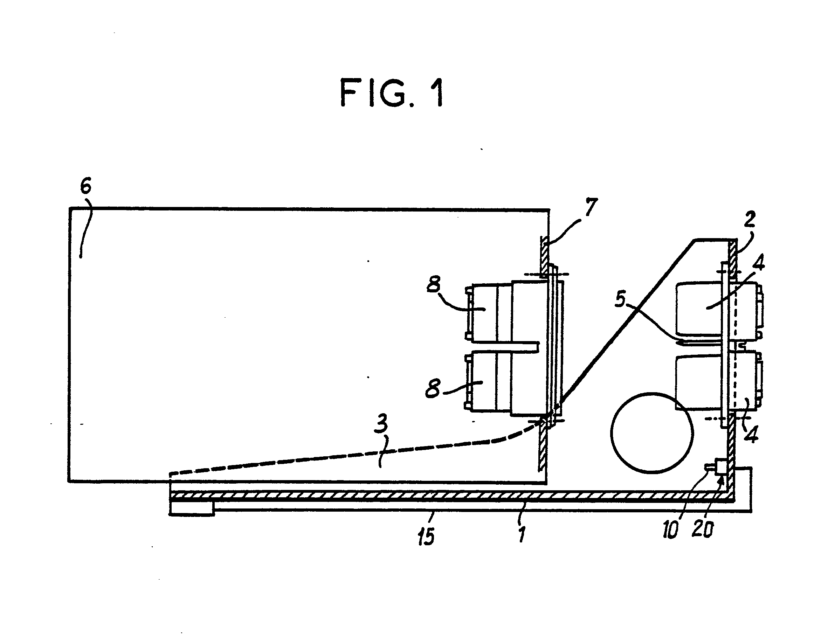

Le plateau d'aéronef représenté, qui est en général monté avec un certain nombre de plateaux identiques sur un rack, présente une base horizontale 1 avec une paroi postérieure verticale 2 et deux bords latéraux de guidage 3 dont la forme apparaît bien sur la figure 1. La paroi postérieure 2, dont la face tournée vers l'avant constitue un plan de référence, présente des connecteurs 4 destinés à l'enfichage en direction horizontale, des moyens de guidage et/ou de détrompage 5 pouvant être prévus.

L'équipement électrique est contenu à l'intérieur d'un boîtier parallélépipédique 6 qui présente sur sa face antérieure différents moyens de réglage, visualisation etc... ainsi que des moyens pour être bloqué, une fois qu'il est positionné convenablement sur le plateau d'aéronef, par des verrous d'enfichage d'un type usuel (non représentés). La face postérieure 7 du boîtier 6 sert également de plan de référence. Cette face comporte des connecteurs 8 complémentaires aux connecteurs 4 et on comprend que si l'on fait glisser le boîtier 6 vers le fond 2 en étant guidé par la partie horizontale 1 et, latéralement, par les bords 3, les connecteurs 4, respectivement 8, finissent par s'enficher pour réaliser la connexion électrique souhaitée.

Comme cela a été expliqué, il importe que le positionnement axial, à l'état verrouillé du boîtier 6 sur le plateau 1, corresponde à un enfichage correct des connecteurs et par conséquent à un degré de probabilité élevé d'un bon contact électrique. En d'autres termes, compte tenu des tolérances de fabrication, lorsque le boîtier 6 est dans sa position finale sur le plateau d'aéronef, la distance horizontale entre la face antérieure de la paroi 2 et la face postérieure de la paroi 7 doit posséder une certaine valeur bien définie avec une faible tolérance permise, notamment vers la direction d'extraction, c'est-à-dire vers la gauche sur la figure 1.

Conformément à l'invention, au moins un interrupteur 20 avec son poussoir 10 est solidaire du plateau d'aéronef, de préférence solidaire de la paroi postérieure 2, et dans ce cas de préférence à une certaine hauteur au-dessus de la paroi horizontale 1, et ceci dans une position axiale, c'est-à-dire horizontale, telle que lorsque la face postérieure de la paroi 7 du boîtier 6 est arrivée dans sa position optimale, le poussoir 10 ait été repoussé et le contact assuré à l'intérieur de l'interrupteur.

Conformément à l'invention, on a fixé sous la face horizontale 1 du plateau d'aéronef, et de préférence à proximité respectivement des deux bords latéraux 3 afin de ne pas gêner le positionnement de verrous de blocage, d'une part un boîtier 16 avec, en son centre, un collecteur 17 pour fibres optiques. Ce collecteur 17 est conçu de façon en soi connue, pour transmettre, à un faisceau de fibres optiques, la lumière qu'il collecte lorsque la face antérieure du boîtier 16 se trouve illuminée sous une incidence variable, par exemple à l'aide d'une lampe de poche. De même, du côté de l'autre bord 3, on a fixé un boîtier 18 dont la face antérieure présente un indicateur lumineux qui peut être un amplificateur et/ou un diffuseur pour fibres optiques.

Des fibres optiques 15, représentées de façon tout à fait schématique en figure 1, relient d'une part le boîtier 16 à l'interrupteur 20 et d'autre part l'interrupteur 20 au boîtier 18. Le circuit qui va ainsi du boîtier 16 vers le boîtier 18 est normalement interrompu par l'interrupteur 20 tant que son poussoir 10 n'est pas sollicité.

Si par contre, l'opérateur fait glisser un boîtier 6 sur le plateau d'aéronef jusqu'à obtention de la position correcte, le poussoir 10 de l'interrupteur 20 est sollicité, et le circuit est établi. L'indicateur lumineux 19 du boîtier 18 montre alors que la position du boîtier 6 sur le plateau d'aéronef est correcte, ce qui correspond à un bon enfichage des connecteurs 4, 8.

L'indicateur 19, par exemple de couleur verte, peut également consister en une indication graphique ou écrite telle qu'un pictogramme ou un message.

De préférence, on utilisera plusieurs interrupteurs, tels que 20, de façon que, même si l'un d'entre eux est détérioré, il suffit qu'un autre fonctionne pour obtenir l'illumination souhaitée.

Dans une autre forme de réalisation, on peut utiliser plusieurs interrupteurs disposés en série, ceci afin d'éviter que le blocage intempestif de l'un des interrupteurs ne produise une fausse réponse positive.

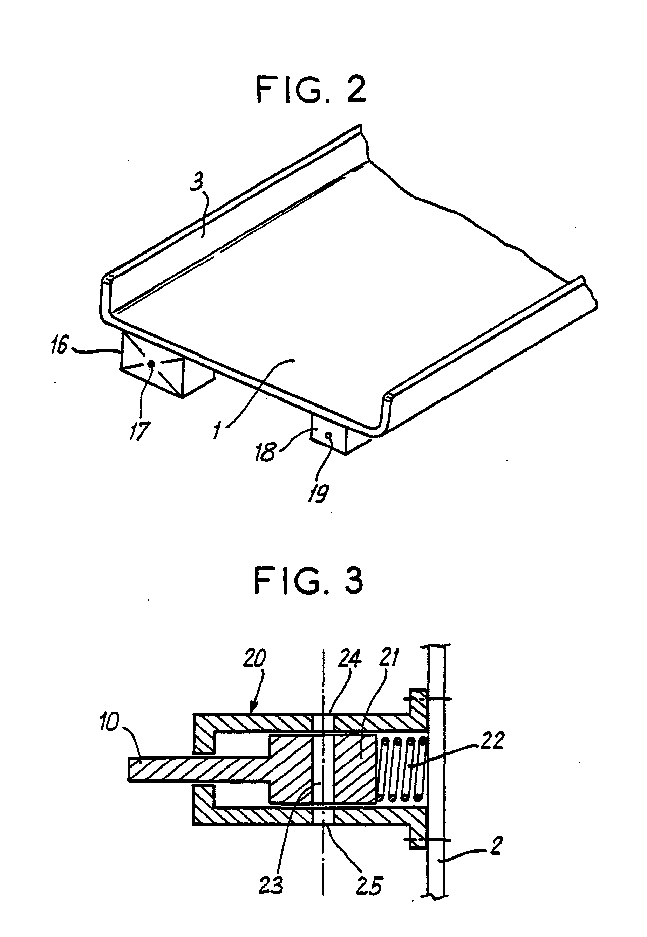

La figure 3 montre, en coupe, un interrupteur 20 dans lequel coulisse un tiroir 21 entraîné, à l'encontre d'un ressort 22, par le poussoir 10, dont la position, au repos, est exactement la même que celle du poussoir de la figure 1. Le tiroir 21 est traversé transversalement par un passage 23 qui, dans la position repoussée vers l'arrière par la face postérieure 7 du boîtier, se trouve en alignement avec deux orifices 24, 25 du boîtier, alors que, dans la position de repos, le ressort 22 repousse le tiroir 21 vers l'avant hors d'alignement avec les orifices 24, 25.

A l'orifice 24 aboutit l'extrémité d'un premier tronçon de faisceau de fibres optiques dont l'autre extrémité est montée dans le boîtier 16 pour recevoir la lumière par le collecteur 17. Il en résulte que lorsque l'interrupteur 20 se trouve dans la position représentée sur la figure 3, l'illumination du collecteur 17 à l'aide d'une lampe de poche entraîne le passage de la lumière dans le tronçon de fibres jusqu'à l'orifice 24 et de là, à travers le passage 23, vers l'orifice 25 où se trouve disposé un collecteur pour un second faisceau de fibres optiques qui est monté entre l'orifice 25 et le boîtier 18 où il permet de délivrer la lumière à l'indicateur lumineux 19. Ainsi l'illumination de la face antérieure du boîtier 16 avec une lampe de poche ne provoque la visualisation d'une indication lumineuse sur la face antérieure du boîtier 18 que lorsque l'interrupteur se trouve dans la position correspondant à un enfichage parfait des connecteurs du boîtier et du plateau d'aéronef.

Bien entendu, on comprend également que la position et l'agencement des moyens optiques et des moyens de visualisation destinés à être actionnés par l'illumination de ceux-là, peuvent varier, étant entendu que l'on préfère séparer d'une part les moyens destinés à être illuminés et d'autre part les moyens de visualisation pour que le rayonnement d'une source de lumière ne parvienne pas en même temps que les moyens de visualisation.

## Revendications

1. Plateau d'aéronef recevant un boîtier d'équipements électroniques portant à sa face postérieure (7) des connecteurs électriques (8), lequel plateau comporte un fond (1), une paroi postérieure (2) portant des connecteurs électriques (4), des bords latéraux (3) de guidage, caractérisé en ce qu'il comporte un dispositif de contrôle du bon enfichage des connecteurs (4, 8) entre eux, ce dispositif de contrôle étant constitué de moyens optiques (17) disposés vers le bord antérieur du plateau d'aéronef, de moyens de visualisation (18), disposés également vers le bord antérieur du plateau d'aéronef, de fibres optiques (15) entre les moyens optiques (17) et les moyens de visualisation (18) et un interrupteur optique (20) présentant un poussoir (10) pouvant être repoussé, à l'encontre des moyens élastiques, par la face postérieure du boîtier (6), lorsque celui-ci parvient à sa position reculée correspondant à la position arrière du boîtier (6) pour laquelle l'enfichage est parfaitement réalisé, ledit interrupteur (20) interrompant le passage d'un signal entre les moyens optiques et les moyens de visualisation quand le poussoir n'est pas sollicité, et autorisant au contraire le passage du signal quand le poussoir est sollicité lorsque la face postérieure du boîtier parvient dans sa position reculée.

2. Plateau selon la revendication 1, caractérisé en ce que les moyens optiques (17) et les moyens de visualisation (18) sont disposés sur le plateau, au bord antérieur de celui-ci.

3. Plateau selon la revendication 2, caractérisé en ce que les moyens optiques (17) et les moyens de visualisation (18) sont écartés l'un de l'autre pour qu'on puisse adresser un rayonnement lumineux aux moyens optiques (17) sans illuminer simultanément les moyens de visualisation (18).

4. Plateau selon l'une quelconque des revendications 1 à 3, caractérisé en ce que le dispositif de contrôle comporte plusieurs interrupteurs disposés en parallèle.

5. Plateau selon l'une quelconque des revendications 1 à 3, caractérisé en ce que le dispositif de contrôle comporte plusieurs interrupteurs disposés en série.

6. Plateau selon l'une quelconque des revendications 1 à 5, caractérisé en ce que les moyens de visualisation (18) comportent des moyens d'affichage d'une indication.

## Claims

1. An airborne instrument panel adapted to receive an electronic equipment housing provided with electrical connectors (8) at its rear face (7), and comprising a bottom (1), a rear wall (2) designed to support electrical connectors (4), and lateral guiding edges (3), characterized in that it comprises a device for checking the perfect mutual plug-in of the connectors (4, 8), said checking device being constituted of optical means (17) disposed towards the front edge of the instrument panel, display means (18) also disposed towards the front end of the instrument panel, optical fibres (15) between the optical means (17) and the display means (18), and an optical switch (20) having a push-button (10) adapted to be pushed back against counteracting resilient means by the rear face of the housing (6), when the latter reaches its backward position corresponding to the rear position of the housing (6), and to a perfect plug-in, said switch (20) being conceived to interrupt the transmission of a signal between the optical means and the display means in the event that the push-button is not urged, and allowing by contrast the transmission of the signal when the push-button is urged by the rear face of the housing reaching its backward position.

2. A panel according to claim 1, characterized in that the optical means (17) and the display means (18) are disposed beneath the panel, at its front edge.

3. A panel according to claim 2, characterized in that the optical means (17) and the display means (18) are spaced apart from one another so that a light radiation can be directed on the optical means (17) without simultaneously lightening the display means (18).

4. A panel according to any one of the claims 1 to 3, characterized in that the checking device comprises several switches disposed in parallel.

5. A panel according to any one of the claims 1 to 3, characterized in that the checking device comprises several switches disposed in series.

6. A panel according to any one of claims 1 to 5, characterized in that the display means (18) comprise means for displaying an indication.

## Patentansprüche

1. Instrumentenplatte eines Flugzeugs zur Aufnahme eines Elektronikgerätegehäuses, das an seiner Rückseite (7) mit elektrischen Anschlüssen (8) ausgestattet ist, wobei die Platte einen Boden (1), eine Rückwand (2) mit elektrischen Anschlüssen (4) und seitliche Führungsränder (3) aufweist, dadurch gekennzeichnet, daß die Platte eine Vorrichtung zur Kontrolle des korrekten Zusammensteckens der Anschlüsse (4, 8) aufweist, wobei die Kontrollvorrichtung aus zum vorderen Rand der Instrumentenplatte hin angeordneten optischen Mitteln (17), aus Anzeigemitteln (18), die ebenfalls zum vorderen Rand der Instrumentenplatte hin angeordnet sind, aus zwischen den optischen Mitteln (17) und den Anzeigemitteln (18) befindlichen optischen Fasern (15) und aus einem optischen Schalter (20) besteht, der eine durch die Rückseite des Gehäuses (6) gegen elastische Mittel betätigbare Drucktaste (10) besitzt, wenn diese Rückseite ihre rückgesetzte, der hinteren Stellung des Gehäuses entsprechende Stellung einnimmt, wobei der Schalter (20) den Durchtritt eines Signals zwischen den optischen Mitteln und den Anzeigemitteln verhindert, wenn die Drucktaste nicht betätigt ist, aber den Durchtritt des Signals ermöglicht, wenn die Drucktaste niedergedrückt ist, aufgrund der Tatsache, daß die Rückseite des Gehäuses in ihre rückgesetzte Stellung gelangt.

2. Platte nach Anspruch 1, dadurch gekennzeichnet, daß die optischen Mittel (17) und die Anzeigemittel (18) am vorderen Rand der Platte angeordnet sind.

3. Platte nach Anspruch 2, dadurch gekennzeichnet, daß die optischen Mittel (17) und die Anzeigemittel (18) gegenseitig auf Abstand gehalten sind, damit ein Lichtstrahl ohne gleichzeitiges Anleuchten der Anzeigemittel (18) auf die optischen Mittel (17) gelenkt werden kann.

4. Platte nach einem beliebigen der Ansprüche 1 bis 3, dadurch gekennzeichnet, daß die Kontrollvorrichtung mehrere parallelgeschaltete Schalter aufweist.

5. Platte nach einem beliebigen der Ansprüche 1 bis 3, dadurch gekennzeichnet, daß die Kontrollvorrichtung mehrere in Reihe geschaltete Schalter aufweist.

6. Platte nach einem beliebigen der Ansprüche 1 bis 5, dadurch gekennzeichnet, daß die Anzeigemittel (18) Mittel zum Aufleuchtenlassen einer Anzeige aufweisen.

# FIG. 1

# FIG. 2

# FIG. 3